# EUROPEAN PATENT SPECIFICATION

(11) **EP 0 372 873 B1**
(45) Date of publication and mention of the grant of the patent: **24.09.1997**
(21) Application number: 89312595.5
(22) Date of filing: 01.12.1989
(51) Int. Cl.: G11C 7/00

(54) **Integrated-circuit configuration having fast local access time**
Integrierte Schaltungskonfiguration mit schneller örtlicher Zugriffszeit
Configuration de circuit intégré ayant un temps d'accès local rapide

(30) Priority: 05.12.1988 US 279758
(43) Date of publication of application: 13.06.1990
(73) Proprietor: TEXAS INSTRUMENTS INCORPORATED, Dallas Texas 75265 (US)
(72) Inventor: Ashmore, Benjamin H., Houston Texas 77071 (US)
(74) Representative: Abbott, David John

(56) References cited:
- EP-A- 0 129 651
- EP-A- 0 199 134
- US-A- 4 675 850
- US-A- 4 817 058
- IEEE JOURNAL OF SOLID-STATE CIRCUITS. vol. 23, no. 5, October 1988, NEW YORK US pages 1133 - 1139; PINKHAM ET AL: "A 128Kx8 70-Mhz Multiport Video RAM with Auto Register Reload and 8x4 Block WRITE Feature"
- IEEE INTERNATIONAL SOLID STATE CIRCUITS CONFERENCE. vol. 32, 15 February 1989, NEW YORK US pages 40 - 41; ASHMORE ET AL: "A 20ns 1Mb Burst Mode EPROM"
- ELECTRONIC DESIGN. vol. 33, no. 22, 19 September 1985, HASBROUCK HEIGHTS, NEW JERSEY pages 171 - 174; SIMON M. PRICE: "CMOS 256/kbit video RAM, with wide two-way bus, picks up speed, drops power" - also pages 176, 178
- ALAN CLEMENTS 'Microprocessor Systems Design' 1987 , PWS , BOSTON, MASSACHUSSETTS, US; page 139, line 10 - page 140, line 43; figures 4.18, 4.19
- PATENT ABSTRACTS OF JAPAN vol. 11, no. 378 (P-645) 10 December 1987 & JP-A-62 146 490
- PATENT ABSTRACTS OF JAPAN vol. 12, no. 436 (P-787) 17 November 1988 & JP-A-63 164 096
- PATENT ABSTRACTS OF JAPAN vol. 12, no. 408 (P-778) 28 October 1988 & JP-A-63 144 492
- IEEE TRANSACTIONS ON ELECTRON DEVICES. vol. 32, no. 2, February 1985, NEW YORK US pages 498 - 501; NARITA ET AL: "A High-Speed 1-Mbit EPROM with a Ti-Silicided Gate", page 498, right column, line 9 - line 24; figure 2
- Electronic Design, 18.08.83, p.101

## Description

### BACKGROUND OF THE INVENTION

This invention relates to integrated circuits with memory arrays and, in particular, to circuits for decreasing the time interval between the request from a microprocessor for access to data stored in such memory arrays and the subsequent transmission of such data to the microprocessor.

Improvements in microprocessor speeds of performance have been outpacing corresponding improvements in access time for high-density, non-volatile, semiconductor memories, such as EPROMs. The disparity in required-versus-available memory-array access time has grown larger as a result of recently developed digital-signal-processor (DSP) and reduced-instruction-set-computer (RISC) microprocessor architectures. To utilize a microprocessor's performance capability fully, system designers have resorted to complex architectures such as memory interleaving and high speed static-random-access-memory (SRAM) caches. The alternative has been to compromise system performance by slowing microprocessor access to memory arrays through use of wait states, which previously have been required for every access. Accordingly, there is a need for an improved integrated memory array configuration that minimizes total access time for use in microprocessor system applications without resort to complex circuit architectures.

Studies have shown that microprocessor code typically exhibits a high degree of both linearity and locality. Many microprocessor architectures linearize memory access requests because of on-chip cache burst fill modes or because of instruction pre-fetch queues. When using those microprocessor modes or architectures, a large percentage of total access time involves accessing relatively small part of the data stored in a memory array during a relatively large percentage of the address sequences.

In "IEEE Journal of Solid-State Circuits", vol.23, No.5, dated October 1988, pages 1133-1139, there is a paper entitled "A 128k x 8 70-MHz Multiport Video RAM with Auto Register Reload and 8 x 4 Block WRITE Feature". That paper discloses in Figure 10 the block diagram of the entire chip which has an output buffer into which data can be transferred in parallel from the RAM through a transfer gate and from which the data is serially read out. The preamble of claim 1 is loaded on this prior art.

In JP-A-63-164096 there is disclosed a memory device having a DRAM that, in order to speed up the operation of the RAM, is operated in a page mode or a static column mode depending on whether or not a HIT signal is emitted by a comparator that compares a new external ROW address with the previous refresh ROW address. The DRAM is provided with an output buffer which is loaded with the data corresponding to the refresh row address. Upon a HIT, the data of the external row address is already present in the output buffer for immediatly further use. A comparison of address portions is not involved in this method.

In " Electronic Design" dated 18 August 1983, page 101, there is a discussion of addressing modes used with dynamic RAM's. One of the modes mentioned is the page-mode in which the row address is locked in first and then new column addresses are entered with column address strobe signals. A faster, extended version known as Ripple mode is also referred to as capable of reducing the read/write time to one third of the standard such time.

A semiconductor memory device is disclosed in United States Patent No. 4,675,850 which is selectively operable in a page mode or a nibble mode. The memory device includes a number of data registers connected between the memory array and an output buffer. The data registers hold data applied there in parallel until they are serially output the ouput buffer. However, address comparison is made.

### SUMMARY OF THE INVENTION

According to the present invention there is provided a memory circuit for providing data at output terminals in response to receiving address information and control signals, the memory circuit comprising:
an array of memory cells capable of storing data;
sense amplifiers connected to the array of memory cells;
a line buffer of data latches connected between the sense amplifiers and the output terminals, each data latch being connected between an associated one of the sense amplifiers and an output terminal;
said memory circuits further comprising control circuits, said control circuits being responsive to receipt of a first portion of said address information and to said control signals and to receipt of a second portion of said address information and to said control signals, said first address portion and said control signals causing the memory circuit to transmit data from the memory array through said sense amplifiers to the line buffer of data latches, and said second address portion and said control signals causing the memory circuit to transmit data from the line buffer of data latches to the output terminals;
characterised in that the memory circuit further comprises address comparison means for comparing the first portion of said address information with the first portion of the preceding address information, and where a match occurs, for causing the memory circuit to omit said transmission of data from the memory array to said line buffer of data latches.

The integrated circuit memory array configuration of this invention provides improved access time through use of a statistical approach to performance enhancement and is marketed under the " BURSTMODE" trademark. Specifically, an example of an electrically programmable, read-only-memory (EPROM) described in this invention is organised as a 64K x 16b non-volatile memory array and contains an on-chip 32-byte line buffer circuit and a control logic circuit that take advantage of instruction and data stream linearity and locality. Access to memory locations is considered " local" is the required instruction or data address remains within the current address range of the contents in the line buffer circuit. These " local" data are stored in the line buffer and may be accessed very quickly by the microprocessor, typically within 20 nanoseconds. When a memory cycle requests "non-local" data that are not stored in the line buffer, wait states are needed to allow time to reload the line buffer circuit, which typically occurs within 70 nanoseconds. Because of the predominately linear memory access sequences and because of the large degree of local" address data request, the ratio of "local" data requests to "non-local" data requests is high in many microprocessor applications. In these applications, the average program execution time using the configuration of this invention approaches the execution time that would be achieved through use of a highspeed, absolute-access-time, non-volatile memory. To simplify system integration and to reduce the number of external parts, the configuration of this invention contains on-chip logic to transmit a " miss" signal to the microprocessor in the event that wait states are needed during reload of the line buffer circuit, transforming "non-local" data to "local" data.

### BRIEF DESCRIPTION OF THE DRAWINGS

The novel features of this invention are set forth in the appended claims. The invention, its features, and its advantages are described below in conjunction with the following drawings:
Figure 1 is a representation, in block diagram form, of the configuration of this invention;
Figure 2 is a representation of memory access hit signals and of corresponding transition signals of this invention;
Figure 3 is a representation of memory access miss signals and of corresponding transition signals of this invention; and
Figure 4 is a representation, in block diagram form, of the system configuration of this invention.

### DETAILED DESCRIPTION OF A SPECIFIC EMBODIMENT

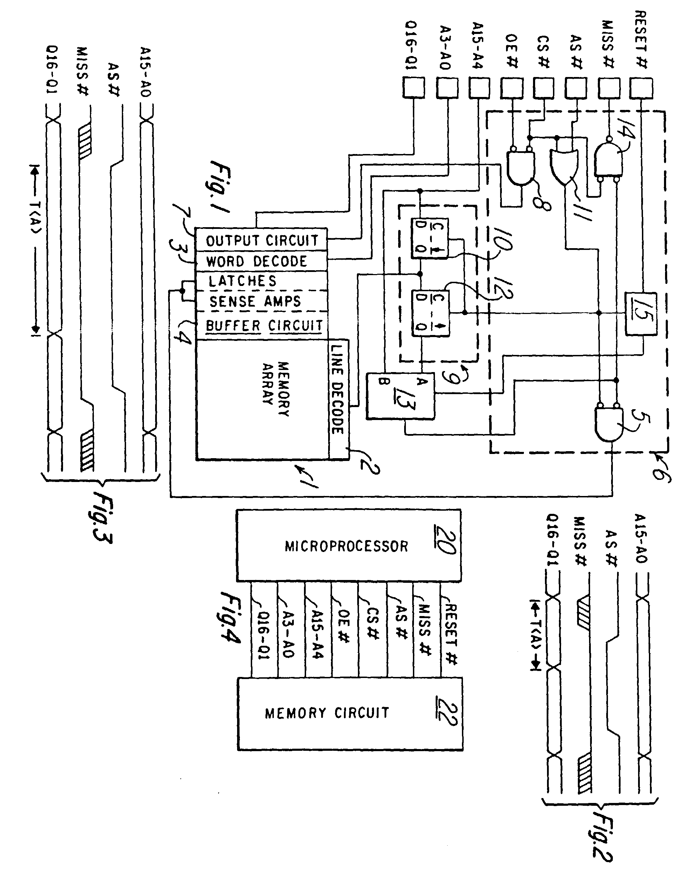

Referring to Figure 1, an embodiment of the non-volatile integrated memory circuit of this invention is shown with an output terminal MISS# that, upon receiving a request for data from a microprocessor, is high when the requested data are readily available (a "hit") and is low when the requested data are not readily available (a "miss"). The microprocessor transmits an address request for data to bus terminals A15-A4 and A3-A0. The part of the address designation that changes most during operation of a program is preferably transmitted to terminal A3-A0 and the part that changes least often is preferably transmitted to terminal A15-A4. A signal at address strobe input terminal AS# is received from a microprocessor and is normally high and drops to a low level at the time the microprocessor wishes to receive the requested data. Chip select terminal CS# receives a high inhibiting signal from the microprocessor if the memory array is not in use. Output enable terminal OE# receives a low signal from the microprocessor at the time the microprocessor accepts data from the memory array through bus terminal Q16-Q1.

The example integrated circuit configuration of Figure 1 includes a memory array 1 of non-volatile memory cells, such as EPROMs, organized as a 64K x 16b array, that includes a standard line-decode circuit 2, and that includes a standard word-decode circuit 3. The input/outputs may, for example, be organized in 128 rows and 512 columns. Line buffer circuit 4 is added to the standard memory array and may include, for example, 256 standard transparent latches grouped in 16 words of 16 bits each. Line buffer circuit 4 is transparent when a high signal is received from first AND circuit 5, which may be included in logic circuit 6. However, line buffer circuit 4 does not bypass information when the signal received from logic circuit 6 is low. The microprocessor selects certain contents of or one word from line buffer circuit 4 by transmitting data address information through terminal A3-A0 to word-decode circuit 3. Output circuit 7 transmits the selected contents of line buffer circuit 4, such as one 16 bit word, to output bus terminal Q16-Q1 when output circuit 7 is activated by a high signal at its triggering input from logic circuit 6, which may include second AND circuit 8. Logic circuit 6, which may include second AND circuit 8, is in turn activated, for example, by low signals from the microprocessor on both the output enable terminal OE# and the chip select terminal CS#.

First and second AND circuits 5 and 8 are shown as inverted input AND circuits, which, as is well-known, are equivalent to NOR circuits.

Pipeline latch circuit 9 is illustrated as including first pipeline latch 10, which in turn may include an array of D-type flip-flop circuits that store address information received from the microprocessor at higher order bus terminal A15-A4 upon detecting a first, perhaps falling signal from the microprocessor at terminal AS# through OR circuit 11, which may be included in logic circuit 6 and which has its second input signal connected to chip select input CS#. Pipeline latch circuit 9, as illustrated, also includes second pipeline latch 12, which in turn may also include an array of D-type flip-flop circuits that store address information received from first pipeline latch 10 upon detecting a fourth, perhaps rising, pulse signal from the microprocessor at terminal AS# through OR circuit 11. Comparison circuit 13 has one set of inputs connected to bus terminals A15-A4 and the other set of inputs connected to the output of second pipeline latch 12. The output of comparison circuit 13 is connected to one of the inputs of first AND circuit 5 and to one of the inputs of NAND circuit 14, which may be included in logic circuit 6. The other input of first AND circuit 5 is connected to the output of OR circuit 11. The other input of NAND circuit 14 is connected to chip select terminal CS#. The output of NAND circuit 14 is connected to the MISS# terminal. Bus terminal A3-A0 is connected to word-decode circuit 3. The output of first pipeline latch 10 is connected to line-decode circuit 2.

OR circuit 11 may include a programmable element for inverting the input from terminal AS# to allow use of the device of this invention with microprocessors that have address strobe signals of opposite polarity than the example described here.

NAND circuit 14 is illustrated with inverted inputs and inverted output, which, as is well-known, is equivalent to an OR circuit. NAND circuit 14 may include a programmable element that allows logic circuit 6 to be programmed for use with a microprocessor that requires a high "miss" signal, rather than the low "miss" signal used in the illustrative embodiment described here.

On each memory access cycle from the microprocessor, a first signal, which may be a falling edge depending on the microprocessor characteristic, at terminal AS# loads the high order addresses A15-A4 into first pipeline latch 10. The address signals in first pipeline latch 10 are transferred to second pipeline latch 12 later in the memory cycle by a fourth signal, which may be a rising edge, at terminal AS#. Comparison circuit 13 continuously compares the address information received from the microprocessor at terminal A15-A4 with the addresses of the previous cycle stored in second pipeline latch 12. If the address information at the two locations is the same, the output of comparison circuit 13 is a second, or "non-miss", signal which is not transmitted to the microprocessor or to buffer circuit 4 by logic circuit 6. If the address information at the two locations is not the same, a third, or "miss", signal is asserted by comparison circuit 13. The third, or "miss", signal is transmitted to logic circuit 6, which sends the signal to the microprocessor and causes an internal memory access to reload line buffer circuit 4. If the microprocessor does not receive the third, or "miss", signal from logic circuit 6, the microprocessor transmits a fourth, or output enable, signal to terminal OE# at a preset relatively short time interval, perhaps 20 nanoseconds in length. If the microprocessor receives the third, or "miss", signal from logic circuit 6, the microprocessor transmits the fourth, or output enable, signal to terminal OE# at a preset relatively long time interval, perrhaps 70 nanoseconds in length.

As shown in Figure 1, a reset circuit 15 may be included in logic circuit 6 to ensure that the first memory access will, upon application of power to the device, always generate a "miss", thus triggering loading of the line buffer circuit 4.

The integrated-circuit configuration of this invention may have an internal data path consisting of perhaps 256 sense amplifiers and 256 data latches included in line buffer circuit 4. During a memory cycle when MISS# is asserted, a row of memory array 1 and the 256 sense amplifiers are powered, the sense amplifiers read the data contents of the row of memory cells and the outputs of the sense amplifiers are read in parallel and stored in the data latches of line buffer circuit 4. Because the memory array described in the Figures is a 16 bit input-output device, this equates to the data in 16 adjacent and addressable memory locations (addressed by A3-A0) being stored in the line buffer circuit 4.

Referring to Figure 2, the signal at bus terminals A15-A4 and A3-A0 is indicated as undergoing transitions at the points marked "X". After the first transition, the signal at terminal MISS# remains high, indicating that the information stored in the requested address is stored in line buffer circuit 4. After the signals at bus terminals A3-A0 have stabilized, the requested data is transmitted to terminal Q16-Q1 from line buffer circuit 4 in a relatively short period of time T(A), measured from the last transition.

Referring to Figure 3, the signal at bus terminals A15-A4 and A3-A0 is again indicated as undergoing transitions at the points marked "X". After the first transition, the signal at terminal MISS# decreases in value, indicating that the information stored in the requested address is not stored in line buffer circuit 4. line butter circuit 4. A relatively longer period of time T(A), measured from the transition, is indicated.

Referring to Figure 4, the microprocessor 20 and memory circuit 20 transmit and receive the signals identified in Figure 1 over leads extending between processor 20 and memory circuit 22.

While this invention has been described with respect to an illustrative embodiment, this description is not intended to be construed in a limiting sense. Upon reference to this description, various modifications of the illustrative embodiment, as well as other embodiments of the invention, will be apparent to persons skilled in the art. For example, the memory array can be volatile memory cells used in a dynamic RAM or DRAM. It is contemplated that the appended claims will cover any such modifications or embodiments.

## Claims

1. A memory circuit for providing data at output terminals (Q1-Q16) in response to receiving address information (A0-A15) and control signals (AS,CS,OE), the memory circuit comprising:
an array (1) of memory cells capable of storing data;
sense amplifiers (in 4) connected to the array (1) of memory cells;
a line buffer of data latches (in 4) connected between the sense amplifiers and the output terminals (Q1-Q16), each data latch being connected between an associated one of the sense amplifiers and an output terminal (Q1-Q16);
said memory circuits further comprising control circuits (10,12,13,5), said control circuits being responsive to receipt of a first portion (A15-A4) of said address information and to said control signals (AS,CS) and to receipt of a second portion (A3-A0) of said address information and to said control signals (AS,CS), said first address portion (A15-A4) and said control signals (AS, CS) causing the memory circuit to transmit data from the memory array (1) through said sense amplifiers to the line buffer of data latches, and said second address portion (A3-A0) and said control signals (AS,CS) causing the memory circuit to transmit data from the line buffer of data latches to the output terminals (Q1-Q16); characterised in that the memory circuit further comprises address comparison means (13) for comparing the first portion (A15-A4) of said address information with the first portion of the preceding address information, and where a match occurs, for causing the memory circuit to omit said transmission of data from the memory array (1) to said line buffer of data latches.

2. A memory circuit according to Claim 1 in which the data latches in the line buffer are arranged in selectable groups and the memory circuit includes means (3) responsive to the second portion of the address information (A3-A0) to select one group of the data latches in the line buffer for transmitting data to the output terminals.

3. A memory circuit according to Claim 1 or Claim 2 in which the control circuits (5,8,10-15) are connected to receive the first portion of the address information (A15-A4) and the control signals (AS,CS), the sense amplifiers and the line buffer of data latches (4) including latches (12) for storing the addresses in the array (1) of the data stored in the data latches of the line buffer and the address comparison means (13) comparing the received address information with the stored address to determine whether to transmit data in the data latches of the line buffer to the output terminals (Q1-Q16) or to transmit data from the array (1) of memory cells to the data latches (in 4) for later transmission to the output terminals (Q1-Q16).

4. A memory circuit according to Claim 3 in which the control circuits include means (14) for transmitting a MISS signal upon the received address information differing from the stored addresses.

5. A memory circuit according to Claim 3 or Claim 4 in which the control circuits include a reset circuit (15) for enabling the transmission of data from the array (1) through the sense amplifiers to the data latches upon power up.

6. A memory circuit according to any one of the preceding claims in which memory cells of the array (1) are non-volatile.

7. A memory circuit according to any one of the preceding claims in which memory cells of the array (1) are electrically-programmable read-only-memory.

8. A memory circuit according to any one of the preceding claims in which the array (1) of memory cells are arranged in rows and columns, the columns representing plural words of data and the address information addressing individual words of data stored in the data latches of the line buffer.

9. A memory circuit according to any one of the preceding claims in which the data latches of the line buffer are arranged in 16 words of data with 16 bits in each word.

10. A processor system comprising:
a processor providing an address signal on parallel address terminals and control signals on control terminals for receiving requested data on parallel data terminals; and
a memory circuit according to any one of the preceding claims connected to the address terminals and having its output terminals connected to the parallel data terminals of the processor.

## Patentansprüche

1. Speicherschaltung für die Bereitstellung von Daten an Ausgangsanschlüssen (Q1-Q16) als Antwort auf den Empfang von Adresseninformationen (A0-A15) und von Steuersignalen (AS, CS, OE), wobei die Speicherschaltung enthält: eine Matrix (1) aus Speicherzellen, die Daten speichern können;
Leseverstärker (in 4), die an die Matrix (1) aus Speicherzellen angeschlossen sind;
einen Leitungspuffer aus Daten-Signalspeichern (in 4), die zwischen die Leseverstärker und die Ausgangsanschlüsse (Q1-Q16) geschaltet sind, wobei jeder Daten-Signalspeicher zwischen einen zugeordneten der Leseverstärker und einen Ausgangsanschluß (Q1-Q16) geschaltet ist;
wobei die Speicherschaltungen ferner versehen sind mit Steuerschaltungen (10, 12, 13, 5), die auf den Empfang eines ersten Abschnitts (A15-A4) der Adresseninformationen und auf die Steuersignale (AS, CS) sowie auf den Empfang eines zweiten Abschnitts (A3-A0) der Adresseninformationen und auf die Steuersignale (AS, CS) ansprechen, wobei der erste Adressenabschnitt (A15-A4) und die Steuersignale (AS, CS) die Speicherschaltung dazu veranlassen, Daten von der Speichermatrix (1) über die Leseverstärker an den Leitungspuffer der Daten-Signalspeicher zu übertragen, und der zweite Adressenabschnitt (A3-A0) und die Steuersignale (AS, CS) die Speicherschaltung dazu veranlassen, Daten vom Leitungspuffer der Daten-Signalspeicher an die Ausgangsanschlüsse (Q1-Q16) zu übertragen;
dadurch gekennzeichnet, daß die Speicherschaltung ferner eine Adressenvergleichseinrichtung (13) enthält, die den ersten Abschnitt (A15-A4) der Adresseninformationen mit dem ersten Abschnitt der vorhergehenden Adresseninformationen vergleicht und bei Auftreten einer Übereinstimmung die Speicherschaltung dazu veranlaßt, die Übertragung von Daten von der Speichermatrix (1) an den Leitungspuffer der Daten-Signalspeicher nicht auszuführen.

2. Speicherschaltung nach Anspruch 1, in der die Daten-Signalspeicher im Leitungspuffer in wählbaren Gruppen angeordnet sind und die Speicherschaltung eine Einrichtung (3) enthält, die auf den zweiten Abschnitt der Adresseninformationen (A3-A0) anspricht, um eine Gruppe der Daten-Signalspeicher im Leitungspuffer zu wählen, um Daten an die Ausgangsanschlüsse zu übertragen.

3. Speicherschaltung nach Anspruch 1 oder Anspruch 2, in der die Steuerschaltungen (5, 8, 10-15) in der Weise angeschlossen sind, daß sie den ersten Abschnitt der Adresseninformationen (A15-A4) und die Steuersignale (AS, CS) empfangen, wobei die Leseverstärker und der Leitungspuffer der Daten-Signalspeicher (4) Signalspeicher (12) enthalten, um die Adressen der in den Daten-Signalspeichern des Leitungspuffers gespeicherten Daten in der Matrix (1) zu speichern, und die Adressenvergleichseinrichtung (13) die empfangenen Adresseninformationen mit der gespeicherten Adresse vergleicht, um zu bestimmen, ob in den Daten-Signalspeichern des Leitungspuffers befindliche Daten an die Ausgangsanschlüsse (Q1-Q16) übertragen werden sollen oder ob Daten von der Matrix (1) aus Speicherzellen an die Daten-Signalspeicher (in 4) für eine spätere Übertragung an die Ausgangsanschlüsse (Q1-Q16) übertragen werden sollen.

4. Speicherschaltung nach Anspruch 3, in der die Steuerschaltungen eine Einrichtung (14) enthalten, die ein VERFEHLT-Signal übertragen, wenn die empfangenen Adresseninformationen sich von den gespeicherten Adressen unterscheiden.

5. Speicherschaltung nach Anspruch 3 oder Anspruch 4, in der die Steuerschaltungen eine Rücksetzschaltung (15) enthalten, die die Übertragung von Daten von der Matrix (1) über die Leseverstärker an die Daten-Signalspeicher beim Einschalten der Leistung freigeben.

6. Speicherschaltung nach irgendeinem der vorangehenden Ansprüche, in der die Speicherzellen der Matrix (1) nichtflüchtig sind.

7. Speicherschaltung nach irgendeinem der vorangehenden Ansprüche, in der die Speicherzellen der Matrix (1) elektrisch programmierbare Festwertspeicher-Zellen sind.

8. Speicherschaltung nach irgendeinem der vorangehenden Ansprüche, in der die Matrix (1) aus Speicherzellen in Zeilen und Spalten angeordnet ist, wobei die Spalten mehrere Datenwörter und die Adresseninformationen, die einzelne Datenwörter adressieren, die in den Daten-Signalspeichern des Leitungspuffers gespeichert sind, repräsentieren.

9. Speicherschaltung nach irgendeinem der vorangehenden Ansprüche, in der die Daten-Signalspeicher des Leitungspuffers in 16 Datenwörtern mit 16 Bits pro Wort angeordnet sind.

10. Prozessorsystem, mit:
einem Prozessor, der an parallelen Adressenanschlüssen ein Adressensignal und an Steueranschlüssen Steuersignale bereitstellt, um an parallelen Datenanschlüssen erforderliche Daten zu empfangen; und
einer Speicherschaltung nach irgendeinem der vorangehenden Ansprüche, die an die Adressenanschlüsse angeschlossen ist und mit ihren Ausgangsanschlüssen an die parallelen Datenanschlüsse des Prozessors angeschlossen ist.

## Revendications

1. Circuit de mémoire pour fournir des données à des bornes de sortie (Q1 à Q16) en réponse à la réception d'information d'adresse (A0 à A15) et de signaux de commande (AS, CS, OE), le circuit de mémoire comprenant :
un réseau (1) de cellules de mémoire capable de stocker des données;
des amplificateurs de lecture (en 4) reliés au réseau (1) de cellules de mémoire ;
une mémoire tampon de ligne de registres de données (en 4) reliée entre les amplificateurs de lecture et les bornes de sortie (Q1 à Q16), chaque registre de données étant relié entre l'un associé des amplificateurs de lecture et une borne de sortie (Q1 à Q16) ;
lesdits circuits de mémoire comprenant en outre des circuits de commande (10, 12, 13, 5), lesdits circuits de commande étant sensibles à la réception d'une première portion (A15 à A4) de ladite information d'adresse et desdits signaux de commande (AS, CS) et à la réception d'une seconde portion (A3 à A0) de ladite information d'adresse et desdits signaux de commande (AS, CS), ladite première portion d'adresse (A15 à A4) et lesdits signaux de commande (AS, CS) commandant le circuit de mémoire pour transmettre des données depuis le réseau de mémoire (1) à travers lesdits amplificateurs de lecture vers la mémoire tampon de ligne de registres de données, et ladite seconde portion d'adresse (A3 à A0) et lesdits signaux de commande (AS, CS) commandant le circuit de mémoire pour transmettre des données depuis ladite mémoire tampon de ligne de registres de données vers les bornes de sortie (Q1 à Q16) ; caractérisé en ce que le circuit de mémoire comporte en outre des moyens de comparaison d'adresses (13) pour comparer la première portion (A15 à A4) de ladite information d'adresse avec la première portion de l'information d'adresse précédente, et lorsqu'une correspondance s'établit, pour commander le circuit de mémoire pour omettre ladite transmission de donnée depuis ledit réseau de mémoire (1) vers ladite mémoire tampon de ligne de registres de données.

2. Circuit de mémoire selon la revendication 1, dans lequel lesdits registres de données dans ladite mémoire tampon de ligne sont agencés suivant des groupes sélectionnables et le circuit de mémoire inclut des moyens (3) sensibles à la seconde portion de l'information d'adresse (A3 à A0) pour sélectionner un groupe de registres de données dans la mémoire tampon de ligne pour transmettre des données vers les bornes de sortie.

3. Circuit de mémoire selon la revendication 1 ou 2, dans lequel les circuits de commande (5, 8, 10 à 15) sont reliés pour recevoir la première portion de l'information d'adresse (A15 à A4) et les signaux de commande (AS, CS), les amplificateurs de lecture et la mémoire tampon de ligne des registres de données (4) incluant des registres (12) pour stocker les adresses dans le réseau (1) des données stockées dans les registres de données dans la mémoire tampon de ligne et les moyens de comparaison d'adresses (13) comparant l'information d'adresse reçue avec l'adresse stockée pour déterminer s'il convient de transmettre des données dans les registres de données de la mémoire tampon de ligne vers les bornes de sortie (Q1 à Q16) ou s'il convient de transmettre des données depuis le réseau (1) de cellules de mémoire vers les registres de données (en 4) pour une transmission ultérieure vers les bornes de sortie (Q1 à Q16).

4. Circuit de mémoire selon la revendication 3, dans lequel les circuits de commande incluent des moyens (14) pour transmettre un signal MISS en réponse à l'information d'adresse reçue différente des adresses stockées.

5. Circuit de mémoire selon la revendication 3 ou 4, dans lequel les circuits de commande incluent un circuit d'initialisation (15) pour permettre la transmission de données depuis le réseau (1) à travers les amplificateurs de lecture vers les registres de données lors d'un allumage.

6. Circuit de mémoire selon l'une quelconque des revendications précédentes, dans lequel des cellules de mémoire du réseau (1) sont non volatiles.

7. Circuit de mémoire selon l'une quelconque des revendications précédentes, dans lequel des cellules de mémoire du réseau (1) sont des mémoires à lecture seule programmable électriquement.

8. Circuit de mémoire selon l'une quelconque des revendications précédentes, dans lequel le réseau (1) de cellules de mémoire est agencé en colonnes et en lignes, les colonnes représentant des mots pluraux de données et des mots individuels d'adressage d'information d'adresse de données stockées dans les registres de données dans la mémoire tampon de ligne.

9. Circuit de mémoire selon l'une quelconque des revendications précédentes, dans lequel les registres de données de la mémoire tampon de ligne sont agencés en seize mots de données avec seize bits dans chaque mot.

10. Système à processeur comprenant :
un processeur fournissant un signal d'adresse sur des bornes d'adresses parallèles et des signaux de commande sur des bornes de commande pour recevoir des données requises sur des bornes de données parallèles ; et
un circuit de mémoire selon l'une quelconque des revendications précédentes relié aux bornes d'adresses et ayant ses bornes de sortie connectées aux bornes de données parallèles du processeur.
